# EUROPEAN PATENT SPECIFICATION

(11) **EP 4 322 212 B1**
(45) Date of publication and mention of the grant of the patent: **25.03.2026**
(21) Application number: 23190372.5
(22) Date of filing: 08.08.2023
(51) Int. Cl.: H01L 23/473, H05K 7/20, H01L 23/373, H01L 23/367

(54) **POWER MODULE, INVERTER, AND VEHICLE**
LEISTUNGSMODUL, WECHSELRICHTER UND FAHRZEUG
MODULE DE PUISSANCE, ONDULEUR ET VÉHICULE

(30) Priority: 08.08.2022 CN 202210942074
(43) Date of publication of application: 14.02.2024
(73) Proprietor: Huawei Digital Power Technologies Co., Ltd., Shenzhen, Guangdong 518043 (CN)
(72) Inventor: WANG, Heng, Shenzhen, 518043 (CN); LI, Jiyang, Shenzhen, 518043 (CN); CHEN, Huibin, Shenzhen, 518043 (CN)
(74) Representative: Gill Jennings & Every LLP

(56) References cited:
- WO-A1-2013/091143
- CN-B- 102 593 317
- JP-A- 2021 182 568
- US-A1- 2013 027 888
- US-A1- 2014 138 075
- US-A1- 2016 190 033
- US-A1- 2023 187 305

## Description

### TECHNICAL FIELD

This application relates to power devices, and to a power module, an inverter, and a vehicle.

### BACKGROUND

An insulated gate bipolar transistor (insulated gate bipolar transistor, IGBT) power module is a core component of direct current-alternating current conversion in electric vehicles. In recent years, with vigorous development of electric vehicles, higher requirements are imposed on performance of the IGBT power module, for example, higher electric energy conversion efficiency, a smaller size and weight, and higher reliability that can adapt to strict vehicle regulation requirements.

For reliability of power devices, in an existing packaging solution, a ceramic layer is used to implement insulation configuration between a chip and the outside, and then a heat dissipation assembly disposed outside the ceramic layer is used to dissipate heat for the chip. In this packaging solution, the ceramic layer provides insulated packaging space for the chip, and the heat dissipation assembly dissipates heat for the chip. The ceramic layer may be connected to the heat dissipation assembly through a silicone ester material. In this way, heat generated by the chip needs to be conducted to the heat dissipation assembly through the ceramic layer and a silicone ester layer for heat dissipation. Thermal conductivity of the ceramic layer is poor, but heat generated by a power module is high because the power module usually needs to perform instantaneous conversion of a high voltage to a low voltage, and consequently, the heat generated by the chip usually cannot be transferred to the outside in a timely manner. As a result, the chip is prone to be damaged, and reliability of the power module is reduced.

WO 2013/091143 A1 describes a microchannel direct bonded copper substrate and a packaging structure and process of a power device thereof.

US 2014/138075 A1 provides heat exchanger suitable for cooling a heat source.

JP 2021 182568 A describes a power module comprising: a first conductor plate bonded to a first power semiconductor element; a second conductor plate bonded to a second power semiconductor element and arranged to be adjacent to the first conductor plate; a first heat dissipation member arranged to face the first conductor plate and the second conductor plate; and a first insulation sheet member arranged between the first heat dissipation member and the first conductor plate.

US 2013/027888 A1 describes that a power module production method produces a power module by stacking a cooler, an insulating resin sheet, a heat sink block , and a semiconductor.

### SUMMARY

This application provides a power module, an inverter, and a vehicle, to improve reliability of the power module.

According to the invention, this application provides a power module in accordance with appended claim 1.

According to the power module of this application, the chip and the heat conducting layer are disposed in the accommodation space formed by the heat dissipation housing. The heat conducting layer with the thermal conductivity coefficient greater than or equal to 200 W/mK is used, so that the heat conducting layer may have ultra-high heat transfer efficiency compared with a ceramic layer, and heat generated by the chip may be quickly transferred to the heat dissipation assembly through the heat conducting layer. In addition, in the power module of this application, the at least a part of the heat dissipation housing of the heat dissipation assembly is the hollow housing. The hollow housing is filled with the insulated fluid medium as the cooling medium. In addition to absorbing the heat transferred from the heat conducting layer to the heat dissipation housing in a timely manner, the cooling medium may further provide an insulated packaging environment for the chip to increase insulation between the chip and external environment components, so that reliability of the power assembly is improved. Therefore, according to the power module of this application, the heat dissipation housing and the cooling medium having an insulation property are used to implement insulation and sealing of the chip, and the ceramic layer does not need to be disposed as an insulation layer additionally. Therefore, thermal resistance of the ceramic layer that is conventionally used as the insulation layer may be eliminated, so that thermal resistance of the power module may be significantly reduced, and heat dissipation performance of the power module can be improved.

In addition, the cooling medium used in the power module of this application may be an oil-cooled medium, and may share a cooling system with an oil-cooled motor, so that a problem that a water-cooled system and the oil-cooled motor cannot be deeply integrated can be resolved.

The cooling medium may be a flowing medium and may be recycled.

The heat sink fins are disposed, so that a heat dissipation area can be increased, and heat dissipation efficiency can be improved.

The heat sink fins are disposed, so that a heat dissipation area can be increased, and heat dissipation efficiency can be improved.

In an optional implementation, the hollow housing includes a packaging plate and a cover plate, the packaging plate is disposed close to the chip, and the cover plate is disposed on a side that is of the packaging plate and that is away from the chip. In an optional implementation, a groove is provided on a side that is of the cover plate and that faces the packaging plate. In another optional implementation, a groove is provided on a side that is of the packaging plate and that faces the cover plate.

In an optional implementation, a difference between a thermal expansion coefficient of the chip and a thermal expansion coefficient of the heat conducting layer is less than or equal to 50%. The heat conducting layer with a similar thermal expansion coefficient to the thermal expansion coefficient of the chip is used, so that a thermal stress between the chip and the heat conducting layer can be reduced, and reliability of a connection between the chip and the heat conducting layer can be further improved.

A thickness of the heat conducting layer is greater than or equal to 2 mm, and is less than or equal to 5 mm. For a transient working condition of the power module, for example, in a conversion process of a high voltage to a low voltage, a thick heat conducting layer is used, so that effective temperature equalization can be implemented, a heat capacity of the entire module can be increased, and a junction temperature of the power module in the transient working condition can be reduced.

In an optional implementation, a material of the heat conducting layer is selected from at least one of copper, aluminum, or diamond.

In an optional implementation, the fluid medium includes cooling oil.

According to a second aspect, this application further provides an inverter in accordance with appended claim 7.

The auxiliary assembly includes but is not limited to a switch, a capacitor, a current sensor, an alternating current terminal block, and the like.

According to a third aspect, this application further provides a vehicle in accordance with appended claim 8.

For technical effects that may be achieved in the second aspect and the third aspect, refer to corresponding effect descriptions in the first aspect. Details are not described herein again.

For data in the foregoing possible implementations of this application, for example, a thermal conductivity coefficient of a heat conducting layer, thickness of the heat conducting layer, and the like, during measurement, values within an engineering measurement error range should be understood as falling within a range limited in this application.

### BRIEF DESCRIPTION OF DRAWINGS

FIG. 1 is a schematic diagram of a structure of an existing IGBT power module,
FIG. 2 is a schematic diagram of a structure of a power module according to an embodiment;
FIG. 3 is a schematic diagram of an exploded structure of a power module according to an embodiment;
FIG. 4 is a schematic sectional view of a structure of a power module according to an embodiment;
FIG. 5 is a schematic diagram of a structure of a power module according to another embodiment of this application; and
FIG. 6 is a schematic diagram of a connection structure of a vehicle according to an embodiment of this application.

Reference numerals:
10: Power module; 11: Chip; 12: Heat dissipation assembly; 121: Heat dissipation housing; 122: Hollow housing; 1221: Packaging plate;
1222: Cover plate; 123: Heat sink fin; 13: Insulation layer; 14: Heat conducting layer; 15: Power terminal; 16: Signal terminal;
17: Support layer; 18: Solder; 19: Adhesive layer; 20: Sealing element;
100: Vehicle; 101: Power battery; 102: Inverter; 103: Engine; and 104: Driving power assembly.

### DESCRIPTION OF EMBODIMENTS

To make the objectives, technical solutions, and advantages of this application clearer, the following further describes this application in detail with reference to the accompanying drawings.

Terms used in the following embodiments are only intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise emphasized in another manner. The terms "include", "comprise", and "have", and variants thereof all mean "include but are not limited to", unless otherwise emphasized in another manner.

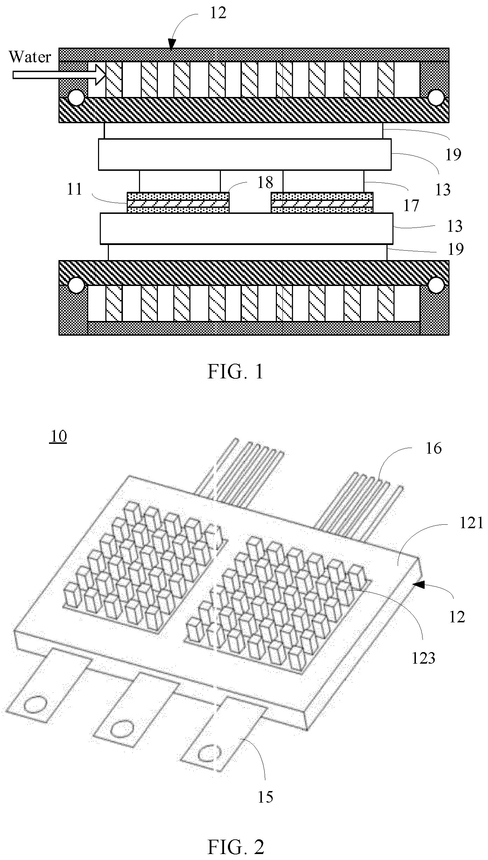

FIG. 1 is a schematic diagram of a structure of an existing IGBT power module. In a packaging structure of the IGBT power module, insulation layers 13, for example, ceramic layers, are usually disposed between chips 11 and a heat dissipation assembly 12, to implement insulation between the chips 11 and the outside. The insulation layers 13 are usually connected to the heat dissipation assembly 12 through adhesive layers 19. The adhesive layers 19 may be silicone ester material layers, to implement full contact between the insulation layers 13 and the heat dissipation assembly 12. Support layers 17 may be further disposed between the chips 11 and the insulation layers 13, to avoid affecting a connection of the chips as a result of direct contact between the insulation layer 13 and the chips 11. In a working process of the IGBT power module, heat generated by the chips 11 may be conducted to the heat dissipation assembly 12 via the support layers 17, the insulation layer 13, and the adhesive layer 19 in sequence. In the packaging structure, due to a low thermal conductivity coefficient of the insulation layers 13, thermal resistance from the chips 11 to the heat dissipation assembly 12 is high, and the heat generated by the chips 11 cannot be discharged in a timely manner. As a result, reliability of operations of the chips 11 is affected.

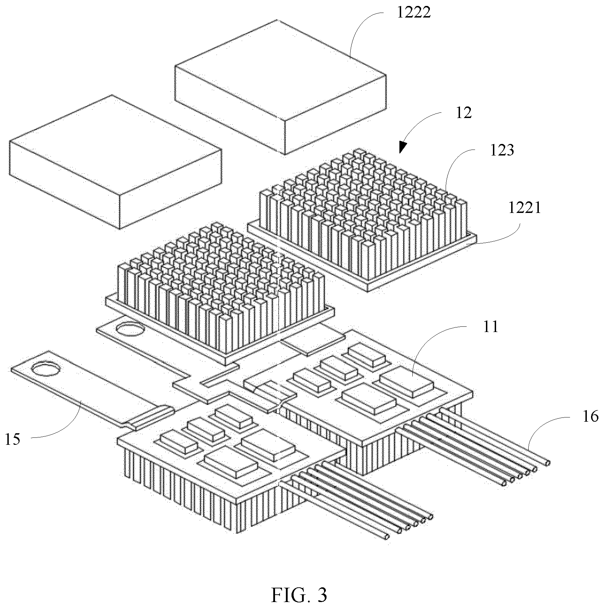

To resolve the foregoing problem, this application provides a power module 10. FIG. 2 is a schematic diagram of a structure of the power module 10 according to an embodiment. FIG. 3 is a schematic diagram of an exploded structure of the power module 10 according to an embodiment. As shown in FIG. 2 and FIG. 3, the power module 10 includes a chip 11, a heat conducting layer 14, and a heat dissipation assembly 12. The heat dissipation assembly 12 is configured to package the chip 11 and the heat conducting layer 14. As shown in FIG. 3, one power module 10 may include a plurality of chips 11, and the plurality of chips 11 may be connected to each other. The chips 11 may implement signal input and output through power terminals 15 and signal terminals 16.

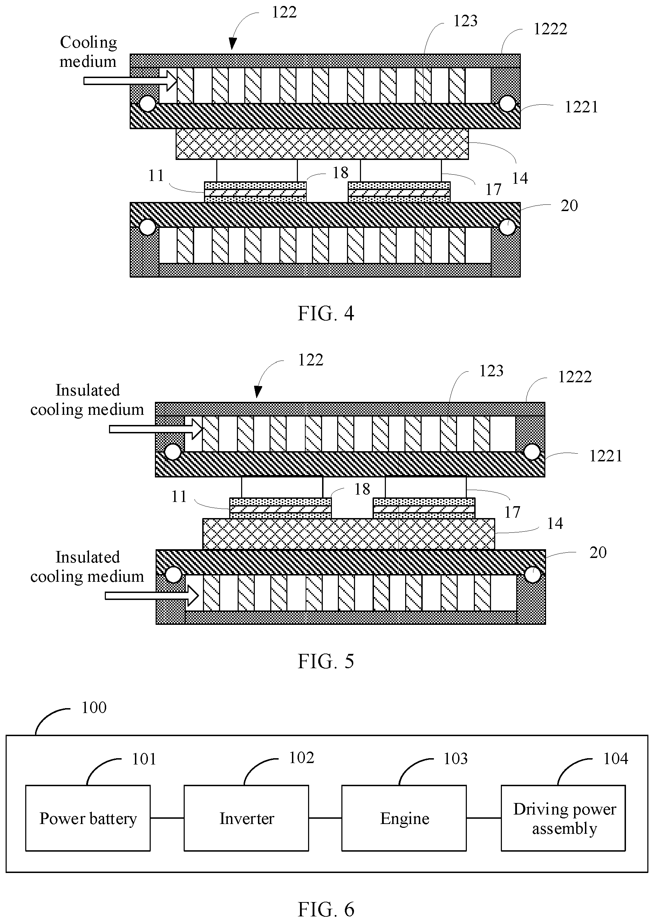

FIG. 4 is a schematic sectional view of a structure of a power module 10 according to an embodiment. As shown in FIG. 4, in the power module 10 in this embodiment of this application, a heat conducting layer 14 is disposed on at least one side of chips 11. Support layers 17 may be disposed between the heat conducting layer 14 and the chips 11. One end of the support layers 17 is connected to the chips 11, and the other end is connected to the heat conducting layer 14. The support layers 17 and the chips 11 may be welded by using a solder 18. An area of the support layers 17 is less than a surface area of the chips 11. The support layers 17 are disposed, so that protection space for the chips 11 can be provided in a thickness direction of the chips 11, to prevent the heat conducting layer 14 from squeezing the chips 11 by directly contacting the chips 11. In addition, the protection space may further facilitate a connection between the chips 11, and facilitate installation and connection of a circuit board or a conducting wire.

Still refer to FIG. 4. A direction shown in FIG. 4 is taken as an example. In an embodiment of this application, the heat conducting layer 14 may be disposed above the chips 11. The heat conducting layer 14 may be connected to the chips 11 through the support layers 17, and a surface of a side that is of the heat conducting layer 14 and that is away from the chips 11 is directly in a contact connection to the heat dissipation assembly 12. In this way, heat generated during an operation process of the chips 11 may be first conducted to the heat conducting layer 14 through the support layers 17, then conducted to the heat dissipation assembly 12 through the heat conducting layer 14, and transmitted to the outside through the heat dissipation assembly 12. In this embodiment of this application, a thermal conductivity coefficient of the heat conducting layer 14 is greater than or equal to 200 W/mK. In this way, rapid heat transfer can be implemented by using the heat conducting layer 14, to conduct the heat generated by the chips 11 to the heat dissipation assembly 12 in a timely manner.

FIG. 5 is a schematic diagram of a structure of a power module 10 according to another embodiment of this application. As shown in FIG. 5, in addition to being disposed above chips 11, a heat conducting layer 14 may be further disposed below the chips 11. In addition, heat conducting layers 14 may be alternatively disposed above and below the chip 11. Herein, a specific disposing position of the heat conducting layer 14 is not limited in this application, and the heat conducting layer 14 may be adjusted based on an installation position of the power module and a heat dissipation environment.

A difference between a thermal expansion coefficient of the chips 11 and a thermal expansion coefficient of the heat conducting layer 14 may be less than or equal to 50%. Therefore, a thermal stress between the chips 11 and the heat conducting layer 14 can be reduced, and a crack in a connection between the chips 11 and the heat conducting layer 14 caused by an excessively large difference of the thermal expansion coefficients can be avoided, so that reliability of the connection between the chips 11 and the heat conducting layer 14 can be improved. For example, a material of the heat conducting layer 14 may be selected from at least one of copper, aluminum, or diamond.

According to the invention, a thickness of the heat conducting layer 14 is greater than or equal to 2 mm, and is less than or equal to 5 mm. For a transient working condition of the power module 10, for example, in a conversion process of a high voltage to a low voltage, a thick heat conducting layer 14 is used, so that effective temperature equalization can be implemented, a heat capacity of the entire module can be increased, and a junction temperature of the power module 10 in the transient working condition can be reduced.

Refer to FIG. 2 to FIG. 5. In the power module 10 according to embodiments of the invention, the heat dissipation assembly 12 includes a heat dissipation housing 121. The heat dissipation housing 121 encloses accommodation space for the chips 11 and the heat conducting layer 14 (FIG. 4 and FIG. 5 show only a part of the heat dissipation housing 121, and do not show the entire heat dissipation housing 121). The chips 11 and the heat conducting layer 14 are located in the accommodation space. The heat dissipation assembly 12 may package and protect the chips 11 and the heat conducting layer 14. The power terminals 15 and the signal terminals 16 that are connected to the chips 11 may extend to the outside of the heat dissipation housing 121, to implement a connection to an external circuit.

Refer to FIG. 4 and FIG. 5. In an embodiment of this invention, at least a part of the heat dissipation housing 121 is a hollow housing 122. The hollow housing 122 is filled with a cooling medium to cool the heat conducting layer 14. The cooling medium is a flowing cooling medium. For example, an inlet and an outlet of the cooling medium may be provided at different positions on the hollow housing 122 for inflow and outflow of the cooling medium. After flowing out of the hollow housing 122, the cooling medium may enter an external cooler to cool the cooling medium.

The hollow housing 122 may be disposed based on a heat dissipation part of the power module 10. As shown in FIG. 4, the hollow housings 122 may be disposed on both an upper part and a lower part of the chips 11. When the heat generated by the chips 11 is transferred upward, the heat may be transferred to the hollow housing 122 through the support layers 17 and the heat conducting layer 14 for heat dissipation. When the heat generated by the chips 11 is transferred downward, the heat may be directly transferred to the hollow housing 122 for heat dissipation. Rapid temperature equalization may be implemented by disposing the heat conducting layer 14. Therefore, compared with a lower heat dissipation path, an upper heat dissipation path may effectively prevent heat accumulation at a specified part. In addition, as shown in FIG. 5, the hollow housing 122 may be separately disposed at the lower part of the chips 11. The heat generated by the chips 11 is conducted to the heat dissipation assembly 12 for heat dissipation through the heat conducting layer 14 disposed below. A specific disposing position of the hollow housing 122 is not specially limited in this application as long as the hollow housing 122 can effectively dissipate heat for the chips 11.

As shown in FIG. 4 and FIG. 5, the heat dissipation assembly 12 further includes heat sink fins 123 disposed inside the hollow housing 122. When the cooling medium flows in the hollow housing 122, the heat sink fins 123 may increase a contact area between the cooling medium and the hollow housing 122, so that a heat dissipation effect can be improved. In addition, the heat sink fins 123 are further disposed on an outer part of the hollow housing 122. When the heat sink fins 123 are disposed on the outer part of the hollow housing 122, a contact area between the hollow housing 122 and an external environment may be increased, so that a heat dissipation effect can be improved.

Still refer to FIG. 4 and FIG. 5. In an embodiment of this application, the hollow housing 122 may be of an integrated structure or a split structure. When the hollow housing 122 is of the split structure, the hollow housing 122 may include a packaging plate 1221 and a cover plate 1222. The packaging plate 1221 is configured to be in contact with the heat conducting layer 14, and the cover plate 1222 covers a surface of the packaging plate 1221. A groove is provided on one side that is of the cover plate 1222 and that faces the packaging plate 1221. In this way, after the cover plate 1222 covers the packaging plate 1221, a hollow cavity may be formed between the packaging plate 1221 and the cover plate 1222, to be filled with the cooling medium. When the hollow housing 122 is formed by the packaging plate 1221 and the cover plate 1222, sealing elements 20, for example, sealing strips, may be disposed between the packaging plate 1221 and the cover plate 1222, to implement a sealed connection between the packaging plate 1221 and the cover plate 1222, to prevent leakage of the cooling medium.

In the power module 10 of the invention, the cooling medium in the hollow housing 122 is an insulated fluid medium. As an example for description, the cooling medium may be, for example, oil. The insulated cooling medium input in the hollow housing 122 may be used as an insulation layer of the heat dissipation assembly, to implement an insulation effect of the power module. In this packaging manner, the insulation layer does not need to be separately disposed, so that a structure of the power module can be simplified. In addition, oil is selected as the cooling medium. When the power module is used in an electric vehicle, for example, cooling oil of a motor may be used as the cooling medium, so that deep integration with a motor system of the electric vehicle can be implemented.

Compared with the structure of the power module of a water-cooled structure shown in FIG. 1, the power module of this application has the following advantages:
(1) Low thermal resistance and a high heat capacity: A test result shows that when an inlet velocity of the cooling medium is 5 lpm, the thermal resistance of the power module with double-sided cooling shown in FIG. 4 is 0.083°C/W. Compare with the equivalent water-cooled power module with double-sided silicone grease shown in FIG. 1, the power module of this application has the thermal resistance that is reduced by 1/3. For a working condition under a transient wave loss input, a simulation result shows that under a low frequency input loss, compared with the water-cooled power module with double-sided silicone grease shown in FIG. 1, the power module of this application has a maximum junction temperature that is reduced by nearly 30°C. The result indicates that the heat capacity of the power module of this application is significantly improved.
(2) The cooling medium of this application is an insulation medium. An insulation medium with excellent heat dissipation performance is used as the cooling medium, so that the heat dissipation performance of the entire power module can be improved and insulation of the entire power module can also be implemented. According to a test, the power module of this application operates safely and reliably, and creates a possibility for deep integration with a motor system of an electric vehicle.

Based on a same technical concept, this application provides an inverter. The inverter may include the power module of embodiments of this application. There may be a plurality of power modules, and the plurality of power modules may be connected in parallel through a synchronization signal interface. In addition, the inverter of this application may further include a connection assembly. The connection assembly includes but is not limited to at least one of a switch, a capacitor, a current sensor, an alternating current terminal block, and the like. The switch, the capacitor, the current sensor, the alternating current terminal block, and another assembly may be electrically connected to wiring terminals of the power module respectively.

Based on a same technical concept, this application provides a vehicle. FIG. 6 is a schematic diagram of a connection structure of a vehicle according to this application. As shown in FIG. 6, the vehicle 100 may include the inverter 102 of embodiments of this application. In addition, the vehicle 100 may further include a power battery 101, an engine 103, and a driving power assembly 104. The power battery 101 is connected to the engine 103 through the inverter 102. The inverter 102 is configured to convert a direct current of the power battery 101 into an alternating current, and supply power to the engine 103. The engine 103 is connected to the driving power assembly 104, and is configured to drive the driving power assembly 104 to operate. The invention is defined by the appended claims.

## Claims

1. A power module (10), comprising a chip (11), a heat conducting layer (14), and a heat dissipation assembly (12), wherein
a thermal conductivity coefficient of the heat conducting layer is greater than or equal to 200 W/mK,
the heat dissipation assembly comprises a heat dissipation housing (121), the heat dissipation housing encloses accommodation space, and the chip and the heat conducting layer are disposed in the accommodation space;
at least a part of the heat dissipation housing is a hollow housing (122), at least one side of the chip is in contact with the hollow housing through the heat conducting layer, the hollow housing is filled with a cooling medium for cooling the heat conducting layer, and the cooling medium is an insulated fluid medium,
wherein an inlet and an outlet are provided in the hollow housing, for the cooling medium flowing into the hollow housing from the inlet and flowing out from the outlet, and
wherein heat sink fins (123) are disposed in the hollow housing, for the cooling medium flowing through spacings between the heat sink fins,
**characterised in that** a thickness of the heat conducting layer is greater than or equal to 2 mm, and is less than or equal to 5 mm,
and **in that** the heat sink fins are additionally disposed on an outer part of the hollow housing

2. The power module according to claim 1, wherein a material of the heat conducting layer is selected from at least one of copper, aluminum, or diamond.

3. The power module according to any one of claims 1 to 2, wherein the fluid medium comprises cooling oil.

4. The power module according to any one of claims 1 to 3, wherein the hollow housing comprises a packaging plate and a cover plate, the packaging plate is disposed close to the chip, and the cover plate is disposed on a side that is of the packaging plate and that is away from the chip.

5. The power module according to claim 4, wherein a groove is provided on a side that is of the cover plate and that faces the packaging plate.

6. The power module according to claim 4, wherein a groove is provided on a side that is of the packaging plate and that faces the cover plate.

7. An inverter, wherein the inverter comprises an auxiliary assembly and the power module according to any one of claims 1 to 6, and the auxiliary assembly is connected to the power module.

8. A vehicle (100), comprising a power battery (101), an engine (103), and the inverter according to claim 7, wherein the inverter is disposed between the power battery and the engine.

## Patentansprüche

1. Leistungsmodul (10), umfassend einen Chip (11), eine wärmeleitende Schicht (14) und eine Wärmeableitungseinheit (12), wobei ein Wärmeleitfähigkeitskoeffizient der wärmeleitenden Schicht größer als oder gleich 200 W/mK ist;
die Wärmeableitungsbaugruppe ein Wärmeableitungsgehäuse (121) umfasst, das Wärmeableitungsgehäuse einen Aufnahmeraum umschließt und der Chip und die wärmeleitende Schicht in dem Aufnahmeraum angeordnet sind;
mindestens ein Teil des Wärmeableitungsgehäuses ein Hohlgehäuse (122) ist, mindestens eine Seite des Chips über die wärmeleitende Schicht mit dem Hohlgehäuse in Kontakt steht, das Hohlgehäuse mit einem Kühlmedium zum Kühlen der wärmeleitenden Schicht gefüllt ist und das Kühlmedium ein isoliertes Fluidmedium ist,
wobei ein Einlass und ein Auslass für das Kühlmedium, das aus dem Einlass in das Hohlgehäuse einströmt und aus dem Auslass ausströmt, in dem Hohlgehäuse bereitgestellt sind und
wobei Wärmesenkenrippen (123) für das Kühlmedium, das durch Abstände zwischen den Wärmesenkenrippen strömt, in dem Hohlgehäuse angeordnet sind,
**dadurch gekennzeichnet, dass** eine Dicke der wärmeleitenden Schicht größer als oder gleich 2 mm ist und kleiner als oder gleich 5 mm ist und dass die Wärmesenkenrippen zusätzlich auf einem äußeren Teil des Hohlgehäuses angeordnet sind.

2. Leistungsmodul nach Anspruch 1, wobei ein Material der wärmeleitenden Schicht aus mindestens einem von Kupfer, Aluminium oder Diamant ausgewählt ist.

3. Leistungsmodul nach einem der Ansprüche 1 bis 2, wobei das Fluidmedium Kühlöl umfasst.

4. Leistungsmodul nach einem der Ansprüche 1 bis 3, wobei das Hohlgehäuse eine Verpackungsplatte und eine Abdeckplatte umfasst, die Verpackungsplatte nahe dem Chip angeordnet ist und die Abdeckplatte auf einer Seite angeordnet ist, die der Verpackungsplatte angehört und die von dem Chip weg ist.

5. Leistungsmodul nach Anspruch 4, wobei eine Nut auf einer Seite angeordnet ist, die der Abdeckplatte angehört und die der Verpackungsplatte zugewandt ist.

6. Leistungsmodul nach Anspruch 4, wobei eine Nut auf einer Seite angeordnet ist, die der Verpackungsplatte angehört und die der Abdeckplatte zugewandt ist.

7. Wechselrichter, wobei der Wechselrichter eine Hilfsbaugruppe und das Leistungsmodul nach einem der Ansprüche 1 bis 6 umfasst und die Hilfsbaugruppe mit dem Leistungsmodul verbunden ist.

8. Fahrzeug (100), umfassend eine Leistungsbatterie (101), einen Motor (103) und den Wechselrichter nach Anspruch 7, wobei der Wechselrichter zwischen der Leistungsbatterie und dem Motor angeordnet ist.

## Revendications

1. Module de puissance (10), comprenant une puce (11), une couche conductrice de chaleur (14) et un ensemble de dissipation thermique (12), dans lequel un coefficient de conductivité thermique de la couche conductrice de chaleur est supérieur ou égal à 200 W/mK ;
l'ensemble de dissipation thermique comprend un boîtier de dissipation thermique (121), le boîtier de dissipation thermique renferme un espace de logement, et la puce et la couche conductrice de chaleur sont disposées dans l'espace de logement ;
au moins une partie du boîtier de dissipation thermique est un boîtier creux (122), au moins un côté de la puce est en contact avec le boîtier creux à travers la couche conductrice de chaleur, le boîtier creux est rempli d'un milieu de refroidissement pour refroidir la couche conductrice de chaleur, et le milieu de refroidissement est un fluide isolant,
dans lequel un orifice d'entrée et un orifice de sortie sont prévus dans le boîtier creux, pour permettre au milieu de refroidissement de s'écouler dans le boîtier creux par l'orifice d'entrée et d'en ressortir par l'orifice de sortie, et
dans lequel des ailettes de dissipation thermique (123) sont disposées dans le boîtier creux, pour permettre au milieu de refroidissement de s'écouler à travers des espacements entre les ailettes de dissipation thermique,
**caractérisé en ce que** l'épaisseur de la couche conductrice de chaleur est supérieure ou égale à 2 mm et inférieure ou égale à 5 mm, et **en ce que** les ailettes de dissipation thermique sont également disposées sur une partie extérieure du boîtier creux.

2. Module de puissance selon la revendication 1, dans lequel un matériau de la couche conductrice de chaleur est choisi parmi au moins l'un du cuivre, de l'aluminium ou du diamant.

3. Module de puissance selon l'une quelconque des revendications 1 à 2, dans lequel le fluide comprend de l'huile de refroidissement.

4. Module de puissance selon l'une quelconque des revendications 1 à 3, dans lequel le boîtier creux comprend une plaque d'encapsulation et une plaque de recouvrement, la plaque d'encapsulation est disposée près de la puce et la plaque de recouvrement est disposée d'un côté de la plaque d'encapsulation et éloignée de la puce.

5. Module de puissance selon la revendication 4, dans lequel une rainure est prévue sur un côté de la plaque de recouvrement et fait face à la plaque d'encapsulation.

6. Module de puissance selon la revendication 4, dans lequel une rainure est prévue sur un côté de la plaque d'encapsulation et fait face à la plaque de recouvrement.

7. Onduleur, dans lequel l'onduleur comprend un ensemble auxiliaire et le module de puissance selon l'une quelconque des revendications 1 à 6, et dans lequel l'ensemble auxiliaire est raccordé audit module de puissance.

8. Véhicule (100), comprenant une batterie d'alimentation (101), un moteur (103) et l'onduleur selon la revendication 7, dans lequel l'onduleur est disposé entre la batterie d'alimentation et le moteur.
